Europäisches Patentamt

European Patent Office

Office européen des brevets

(19)

(11) Veröffentlichungsnummer : **0 050 865**
**B1**

(12) **EUROPÄISCHE PATENTSCHRIFT**

(45) Veröffentlichungstag der Patentschrift :
30.01.85

(21) Anmeldenummer : **81108850.9**

(22) Anmeldetag : **24.10.81**

(51) Int. Cl.4 : **B 65 H 45/107, H 05 H 13/00**

(54) **Einrichtung zum mäanderförmigen Ablegen von Bändern, Gurten und dgl.**

(30) Priorität : **29.10.80 DE 3040765**

(43) Veröffentlichungstag der Anmeldung :
**05.05.82 Patentblatt 82/18**

(45) Bekanntmachung des Hinweises auf die Patenterteilung : **30.01.85 Patentblatt 85/05**

(84) Benannte Vertragsstaaten :
**AT BE CH FR GB IT LI LU NL SE**

(56) Entgegenhaltungen :
**DE-A- 1 802 889**
**US-A- 3 717 335**

(73) Patentinhaber : **Sillner, Georg**
**Buchenstrasse 23**
**D-8411 Zeitlarn (DE)**

(72) Erfinder : **Sillner, Georg**
**Buchenstrasse 23**
**D-8411 Zeitlarn (DE)**

(74) Vertreter : **Wasmeier, Alfons, Dipl.-Ing. et al**
**Postfach 382 Greflingerstrasse 7**
**D-8400 Regensburg (DE)**

## Beschreibung

Die Erfindung bezieht sich auf eine Einrichtung zum mäanderförmigen Ablegen von Bändern, Gurten oder ähnlichen streifenförmigen Endlos-Materialien, insbes. von mit elektrischen oder elektronischen Bauelementen bestückten Gurtbändern.

Die Gurte der Trägerstreifen, z. B. Gurtbänder stehen für die Weiterbearbeitung vorzugsweise auf Spulen aufgerollt zur Verfügung. Dies bedingt einen hohen Platzbedarf der leeren Rollen, eine umständliche Handhabung, eine geringe Kapazität und das Einbringen einer Papierzwischenlage, damit sich die Bauteile gut und einwandfrei abwickeln lassen und sich gegenseitig nicht verletzen.

Um diese Nachteile auszuschalten, bietet sich die sog. Mäanderablage an, in der die Streifen mäanderförmig gefaltet werden, so daß damit eine rechteckförmige, platzsparende Anordnung erzielt wird. Eine derartige Mäanderablage war bisher von Hand vorgenommen worden, deshalb jedoch außergewöhnlich aufwendig und kostspielig.

Aus der DE-OS 18 02 889 ist ein Verfahren und eine Vorrichtung zum zick-zack-förmigen oder mäanderförmigen Falten eines flexiblen Bandes, insbesondere Textilbandes, bekannt. Hierbei wird das zulaufende Band mit Hilfe eines hin- und hergehenden Zuführelementes um zwei im Abstand des Wickelhubes versetzte vertikale Wickelstifte gewickelt, die im Takt der Schlaufenbildung auf- und abbewegt werden. Eine derartige Methode ist relativ kompliziert durchzuführen, der maschinelle Aufwand relativ hoch und das Ergebnis aufgrund der hin- und hergehenden wie auf- und abgehenden Bewegung nicht ausreichend betriebssicher. Insbesondere aber ist die Arbeitsgeschwindigkeit einer derartigen Vorrichtung relativ gering.

Desweiteren ist aus der US-PS 3 717 335 eine Vorrichtung zum mäanderförmigen oder zick-zack-förmigen Falten von streifen- oder bandförmigem Material bekannt, bei dem das Material zuerst eine Knickstation durchläuft, in der Streifen oder das Band Knickstellen abwechselnder Richtung erhält, dann das streifenförmige Material durch eine Führungsvorrichtung geführt wird, die eine auf- und abwärts erfolgende oszillierende Bewegung ausführt, bei der heraustretende Streifen im Takt der ankommenden Knickstellen im Material nach oben und nach unten geworfen wird, damit das Material an kammförmigen oberen und unteren Platten bzw. deren Schultern festgelegt wird, wo es dann von einer zugeordneten oberen und unteren umlaufenden Nockenscheibe spezieller Formgebung erfaßt und in die gefaltete Position gedrückt wird. Eine derartige Vorrichtung ist aufwendig und kompliziert herzustellen, ist für viele Anwendungszwecke nicht anzuwenden, z. B. nicht für mit Bauelementen bestückte Gurtbänder, da die auf den Gurten befindlichen Gegenstände weder die Rollensysteme noch die Führungsvorrichtung durchlaufen können, noch am Austritt der Führungsvorrichtung nach oben und unten geworfen werden dürfen, wenn die Gegenstände nicht beschädigt werden sollen.

Aufgabe der Erfindung ist es, eine Einrichtung der gattungsgemäßen Art so anzugestalten, daß der kontinuierlich aus einer Bestückungsmaschine bestückte Gurtstreifen auf einfache und betriebssichere Weise mit möglichst geringem baulichem Aufwand und möglichst hoher Betriebssicherheit in Mäanderform gefaltet und gestapelt wird.

Dies wird gemäß der Erfindung mit Hilfe einer Einrichtung nach dem kennzeichnenden Teil des Anspruches 1 erreicht.

Weitere Merkmale der Erfindung sind Gegenstand der Unteransprüche.

Die Sammelplattform ist vorzugsweise in Form einer U-förmigen. Rinne ausgebildet, in deren Boden ein I-förmiger bzw. doppelt-T-förmiger Schlitz ausgebildet ist, der sich über die gesamte Breite des Bodens der Rinne erstreckt. Die Drehvorrichtung besteht aus zwei stirnseitigen Scheiben, die miteinander durch Stäbe in gleichem Abstand verbunden sind. Die Drehvorrichtung ist unmittelbar unterhalb des Schlitzes der Rinne angeordnet. Die Stäbe nehmen Schieber auf, und zwar jeweils einen Schieber pro Stab ; die Schieber besitzen jeweils einen Stift, der, wenn der Schieber den kleinsten Abstand vom Boden der Rinne einnimmt, durch die I-förmige Aussparung greifen und dabei das auf dem Boden der Rinne stehend angeordnete Gurtband erfaßt.

Das Falten des Gurtbandes in Mäanderform läuft dabei wie folgt ab :

Das von der Begurtungsmaschine kommende Gurtband wird um einen Stift des Schiebers herumgeführt, der in seiner Endposition die oberste Stellung eingenommen hat, d. h. dem Schlitz am nächsten steht, so daß der Stift durch den Schlitz hindurgreift. Dann wird die Drehvorrichtung in Einführrichtung des Gurtbandes um einen Schritt weitergedreht, so daß der Stift des nächsten Schiebers die oberste Position einimmt und das Gurtband zwischen dem Stift der erstgenannten Schiebers und dem zuletzt genannten Stift zu liegen kommt. Der letztere Stift, der gerade die oberste Position einnimmt, wird durch Hubkolbenbetätigung in axialer Richtung auf die entgegengesetzte Seite der Drehvorrichtung verschoben und legt dabei das Gurtband parallel zum Stab, auf dem der Schieber geführt ist. Anschließend erfolgt eine weitere Drehung der Drehvorrichtung um den nächsten Schritt, so daß das gefaltete Gurtband um den Drehschritt weiter in Stapelrichtung bewegt wird. Durch diese Drehbewegung ist der auf der gleichen Seite befindliche benachbarte Schieber in die oberste Position am Schlitz in Eingriff mit dem Gurtband gebracht worden. Durch den nächsten, in entgegengesetzter Richtung verlaufenden Hub des Hubantriebes wird dieser Schieber in axialer Richtung auf die gegenüberliegende Seite der Drehvorrichtung bewegt, wobei das Gurtband wieder mitgenommen wird und dadurch wieder parallel zum Stab gelegt wird, usw. Auf der Drehvorrichtung sind die Schieber somit so angeordnet, daß jeder Stab einen Schieber aufweist, wobei jedoch die Schieber benachbarter Stäbe auf entgegengesetzten Seiten der Drehvorrichtung angeordnet sind. Die einzige Ausnahme bildet die Startposition für die Einleitung des Faltens, an der auf einer Seite der Drehvorrichtung zwei Schieber unmittelbar nebeneinander im Abstand von einem Drehschritt angeordnet sind, während auf der entgegengesetzten Seite der Abstand zweier benachbarter Schieber drei Drehschritte beträgt. Dies ist deshalb erforderlich, weil zu Beginn der zweite Schieber dieses Paares eine Bewegung auf die entgegengesetzte Seite ausführen kann, während der erste Schieber seine Position beibehält, um ein einwandfreies Falten des Gurtbandes zu erreichen.

Während der schittweise Antrieb der Trommel durch einen Stellmotor oder dgl. vorgenommen wird, werden die Schieber durch eine hin- und hergehende Stange eines doppelt wirkenden Druckzylinders bewegt, wobei für alle Schieber ein einziger Druckzylinder vorhanden ist, da jeweils nur der die oberste Position einnehmende Schieber eine Axialbewegung ausführt. Der Eingriff zwischen dieser Schubstange und dem zugeordneten Schieber erfolgt durch eine Ausnehmung des Schiebers, so daß bei einer Verdrehung der Drehvorrichtung diese Ausnehmung in einen entsprechenden Ansatz der Druckstange gleitet. Die Schieber behalten ihre Endstellung dadurch bei, daß beispielsweise eine Kugel mit Anpreßglied vorgesehen ist, so daß der Schieber in seiner Endstellung einrasten kann ; es kam jedoch auch in der Endposition eine Stelle erhöhter Reibung vorgesehen sein, die ein Verharren des Schiebers an dieser Stelle bewirkt.

In weiterer Ausgestaltung der Erfindung wird vorgeschlagen, daß der Schlitzanordnung eine Sperrvorrichtung zugordnet ist, die unmittelbar nach Beendigung des Faltens des jeweiligen Gurtbandabschnittes mit dem gurtband in Anlage kommt und ein Zurückspringen des Gurtbandes verhindert. Diese Sperre besteht vorzugsweise aus an den beiden Seitenwandungen der Rinne befestigten Federelementen, die in normalem Zustand mit ihren freien Enden von den Seitenwandungen abstehen, durch das gerade gefaltete Gurtband in Verbindung mit der Bewegung, die die Schieberstifte auf das Gurtband ausüben, unter Überwindung der Vorspannung gegen die Seitewände gedrückt werden, so daß damit das Gurtband in der Rinne weiter geschoben werden kann.

Nachstehend wird die Erfindung in Verbindung mit der Zeichnung anhand eines Ausführungsbeispieles erläutert. Die Figuren zeigen :

Figur 1  in perspektivischer Ansicht und schematischer Darstellung eine Gurtsammelplattform mit I-Schiltz,

Figur 2  eine Aufsicht auf die Darstellung nach Fig. 1 mit teilweise gefaltetem Gurtband,

Figur 3  in Prinzipdarstellung und in vergrößertem Maßstab die Seitenansicht der Drehvorrichtung in der Zuordnung zur Plattform,

Figur 4  einen Schnitt entlang der Linie I-I der Fig. 3,

Figur 5  eine Aufsicht auf eine Kerbvorrichtung zur Herstellung der Sollknickstelle,

Figur 6  einen Ausschnitt aus einem Gurtband mit Sollknickstellen, und

Figur 7  in Prinzipdarstellung eine Abwicklung der Drehvorrichtung mit darauf angedeuteten Schiebern.

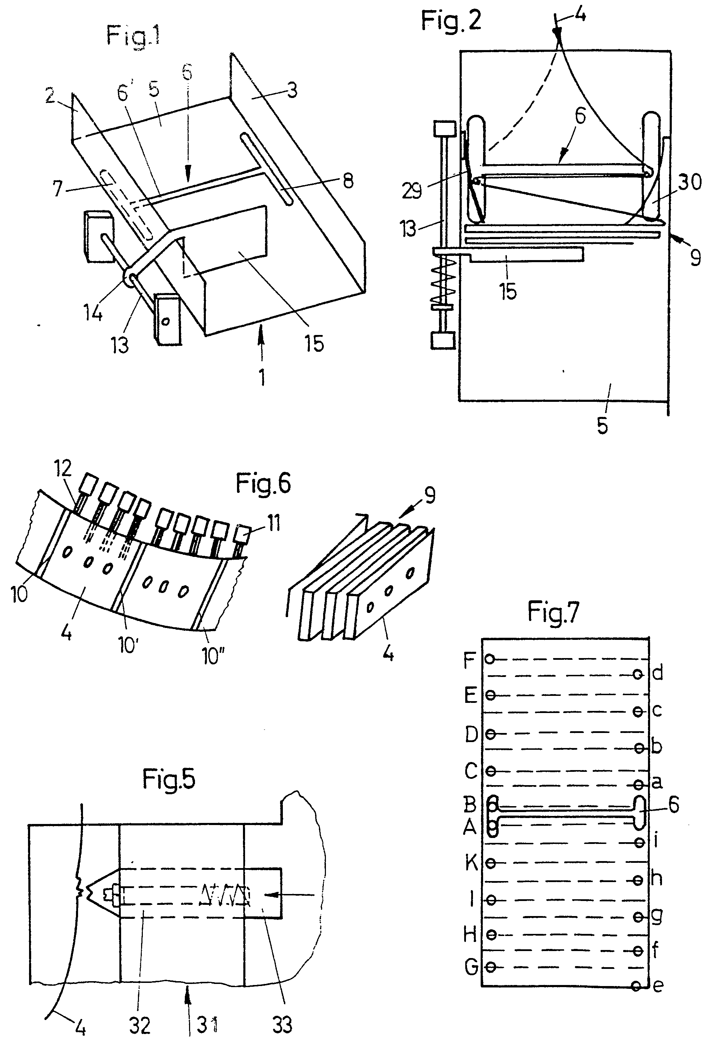

Fig. 1 zeigt eine auf einer Begurtungsmaschine (z. B. nach DE A 3 031 038, offengelegt am 18.3.82) befestigte Sammelplattform 1 mit parallel zur Längsachse verlaufenden Seitenwänden 2, 3 zur Aufnahme des begurteten Trägerstreifens 4. Der Boden 5 der Plattform 1 weist eine schlitzförmige Aussparung 6 auf, die die Form eines Doppel-T- bzw. eines I hat. Der Mittelsteg 6' verläuft dabei quer über die Bodenfläche 5 von einer Seitenwand zur anderen, während die beiden Querbalken 7 und 8 des Schlitzes in unmittelbarer Nähe der Seitenwandungen 2 und 3 senkrecht zum Mittelsteg 6' angeordnet sind. Das Gurtband 4, das der Sammelplattform zugeführt wird, wird auf der Plattform in der in Fig. 2 gezeigten Weise mäanderförmig (bei 9) gefaltet, wie weiter unten noch im einzelnen erläutert wird.

Das einlaufende Gurtband 4 hat Sollknickstellen 10, 10', 10", usw., die einen Abstand voneinander besitzen, der der Breite der Plattform 1 entspricht. Die Sollknickstellen 10, 10', 10" stellen die Kanten der mäanderförmigen Faltung dar. Auf dem Gurtband 4 sind in herkömmlicher Weise zwischen den Sollknickstellen 10, 10' usw. die aufgegurteten Bauteile 11 mit ihren Anschlußdrähten 12 festgelegt. Außerhalb der Plattform 1 ist, wie in Fig. 1 schematisch angedeutet ist, eine Haltevorrichtung 13 für einen Tragarm 14 mit daran befestigter Klappe 15 vorgesehen. Die Klappe 15 ist auf der Achse 13 in der Längsachse der Plattform 1, d. h. in Bewegungsrichtung des gefalteten Gurtbandes, verschiebbar und dient als Anschlag für die angesammelten mäanderförmigen Abschnitte des gefalteten Gurtbandes, indem die Klappe 15 mit Federdruck gegen die Einlaufrichtung des Gurfbandes vorgespannt ist.

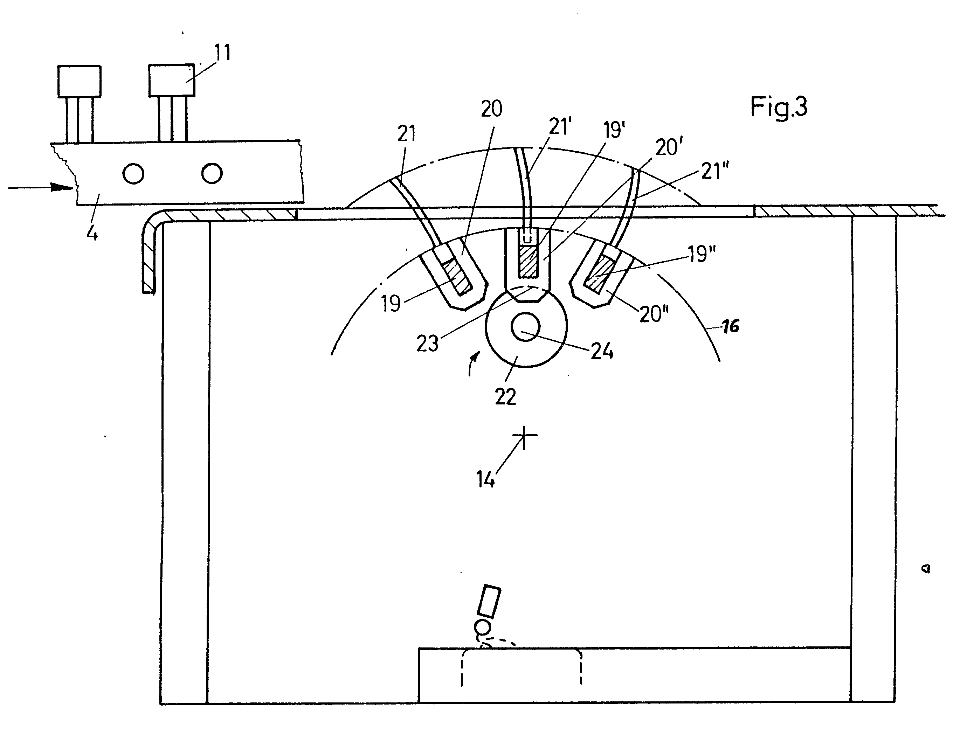

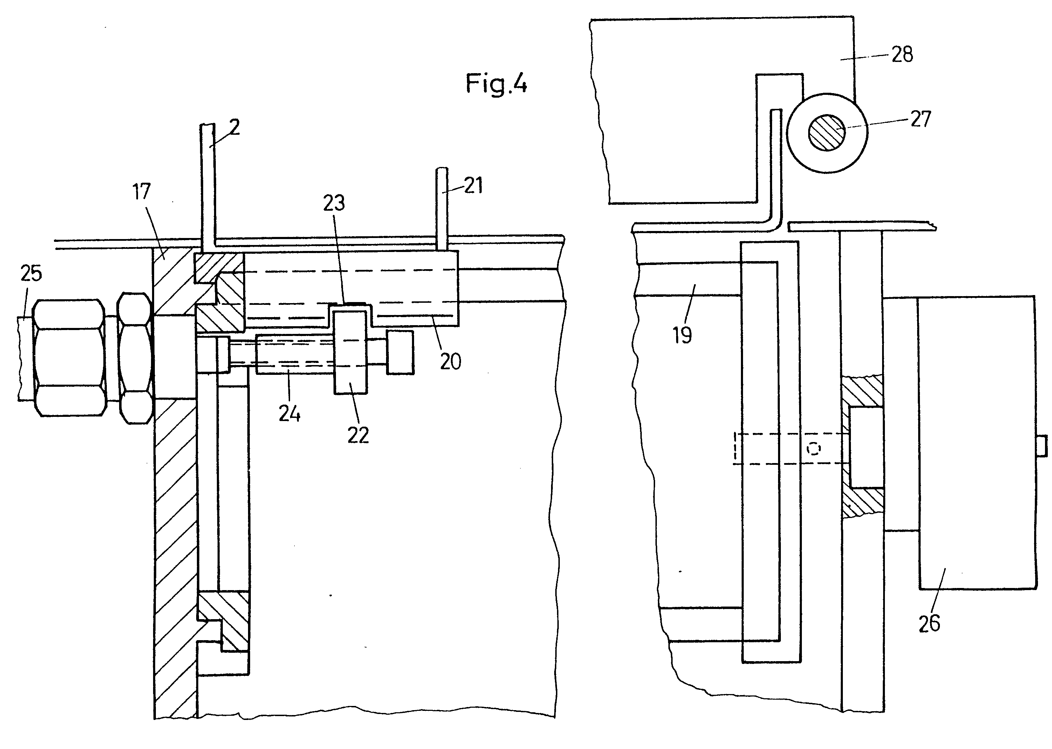

In den Figuren 3 und 4 ist die unterhalb der Plattform 1 angeordnete Drehvorrichtung als Drehtrommel 16 mit Stirnseiten 17, dargestellt, welche über die parallel zueinander und parallel zur Trommellängsachse verlaufenden Stäbe 19, 19', 19" miteinander verbunden sind. Die Stäbe nehmen Schieber 20, 20', 20" auf, die mit Ansätzen bzw. Stiften 21, 21', 21" bestückt sind, welche je nach der Stellung des Schiebers bei einer Drehung der Trommel durch den Schlitz 7 oder 8 bzw. bei einer Verschiebung von der einen zur anderen Seite (17 nach 18 bzw. umgekehrt) durch den Schlitz 6 greifen und der Führung, Positionierung und Weiterbewegung des gefalteten Gurtbandes dienen. Jeweils der oberste Schieber kommt bei einer Drehung der Trommel 16 in Eingriff mit einer Antriebsklaue 22, in die eine Ausnehmung 23 des Schiebers 20 eingreift und die über eine Achse 24 mit einem hin- und hergehenden Antrieb 25, einem doppelt wirkenden Druckzylinder in Verbindung steht. Der Druckzylinder 25 nimmt beim Ausfahren den Schieber 21 bis zum gegenüberliegenden Ende mit, der umgekehrte Bewegungsvorgang spielt sich beim Einzie hen des Druckzylinders ab. Die Drehung der Trommel erfolgt unabhängig hiervon über einen Antriebsmotor 26, der z. B. als Schrittmotor oder als programmgesteuerter Antrieb ausgebildet ist. Mit einer Seitenwand 3 ist ein an einem Scharnier 27 befestigter Klappdeckel 28 verbunden, der als Niederhalter für die mäanderförmig gelegten Gurtbandabschnitte dient und der beispielsweise aus Plexiglas besteht. Desweiteren ist in Höhe des Querschlitzes 6' an den Seitenwänden 2 und 3 je eine nach innen wirkende Blattfeder 29, 30 befestigt, die der Arretierung und Fixierung der gefalteten Gurtbandabschnitte dient. Diese Blattfeder kann auch als Betätiger für einen Quittierschalter dienen, über den der Druckluftzylinder 25 und/oder der Antriebsmotor 26 betätigt werden kann.

Fig. 5 zeigt eine Prägevorrichtung 31 für die im Gurtband 4 vor dem Falten anzubringenden Sollknickstellen. Das Prägewerkzeug 32 ist eine Zweifach-kerbvorrichtung, die das durchlaufende Gurtband mit einer Doppelkerbe versieht. Der Antrieb der Kerbvorrichtung erfolgt über einen (schematisch angedeuteten) Druckluftzylinder 32. Die Kerbvorrichtung wirkt auf das Gurtband in der Weise ein, daß der äußerste Anschlußdraht des aufgegurteten Bauelementes unmittelbar an die Sollknickstelle anschließt.

Fig. 7 zeigt abgewinkelt die Trommel mit den am Trommelumfang versetzt angeordneten Schiebern. Diese Schieber sind mäanderförmig an den Endstellungen der Stäbe versezt und auf den Stäben verschiebbar befestigt, mit der Ausnahme, daß an der Anfangsstelle zwei Schieber der gleichen Seite zugeordnet sind, während auf der gegenüberliegenden Seite zwei Freistellen vorgesehen sind. Anhand der Skizze nach Fig. 7 wird die Arbeitsweise der erfindungsgemäßen Einrichtung erläutert:

Die Schieber auf einer Seite der Trommel sind mit A-K, die Schieber auf der entgegengesetzten Seite mit a-i bezeichnet. Zu Beginn des Faltvorganges wird ein Gurtband 4 von Hand um den Finger des Schiebers A gelegt, der die höchste Position am Schlitz 6 einnimmt, und dort fixiert. Dann wird die Trommel um einen Schritt weitergedreht und der Schieber B auf die entgegengesetzte Seite bewegt, in dem das Band von dem Stift parallel zum Schlitz gelegt und an der Stelle A gefaltet wird. Die Trommel wird anschließend wieder um einen Schritt weitergedreht, so daß der Schieber a in Höhe des Schlitzes 6 zu liegen kommt, wodurch die zu faltende Stelle des Bandes für den Faltvorgang bereitgestellt. ist.

Dann wird der Schieber a nach links bewegt und der Gurtbandabschnitt gelegt. Dort angekommen wird die Trommel wieder um einen Schritt weitergeschaltet, und der Schieber C wird bei stillstehender Trommel nach rechts bewegt. Es erfolgt wieder eine Weiterschaltung der Trommel um einem Schritt, worauf der Schieber b nach links verfahren wird. Die Trommel schaltet weiter, D wird nach rechts verfahren, die Trommel schaltet weiter, c wird nach links verfahren, die Trommel schaltet weiter und E wird nach rechts verfahren. Im Anschluß daran schaltet die Trommel wieder weiter, der Schieber d wird nach links verfahren, usw.

## Ansprüche

1. Einrichtung zum mäanderförmigen Ablegen von Bändern, Gurten oder ähnlichen streifenförmigen Endlos-Materialien, insbes. von mit elektrischen oder elektronischen Bauelementen bestückten Gurtbändern, gekennzeichnet durch eine Sammelplattform (1) zur Aufnahme des gefalteten Gurtbandes (4) mit I-Schlitz (6) im Boden (5) der Plattform (1), und eine dem Schlitz (6) zugeordnete Drehvorrichtung (16) mit mindestens einem axial beweglichen Schieber (20, 20', ...), der zusammen mit der Drehvorrichtung (16) verdrehbar ist und der einen durch den Schlitz (6) hindurchgreifenden Stift (21, 21', ...) in Eingriff mit dem Gurtband (4) besitzt.

2. Einrichtung nach Anspruch 1, dadurch gekennzeichnet, daß die Schieber (20, 20', ...) bei stillstehender Drehvorrichtung (16) in ihrer unmittelbar unterhalb des Schlitzes (6) befindlichen Position in axialer Richtung in Eingriff mit dem Gurtband (4) verschiebbar sind und in ihren axialen Endstellungen zusammen mit der Drehvorrichtung (16) eine Drehbewegung ausführen können.

3. Einrichtung nach Anspruch 1 oder 2, dadurch gekennzeichnet, daß die Drehbewegung der Drehvorrichtung (16) mit den Schiebern (20, 20', ...) und die Axialbewegung jeweils des an dem Schlitz (6) befindlichen Schiebers (20) bei stillstehender Drehvorrichtung (16) absatzweise nacheinander erfolgt, und daß das Gurtband (4) durch die axiale Bewegung des Schiebers (20) von einem Ende zum axial entgegengesetzten Ende der Drehvorrichtung (16) mitgenommen wird, während durch die Drehbewegung der jeweilige Schieber (20) das Gurtband (4) in Drehrichtung auf der Sammelplattform (1) weiterschiebt.

4. Einrichtung nach einem der Ansprüche 1 bis 3, dadurch gekennzeichnet, daß die Drehbewegung der Drehvorrichtung (16) mit den Schiebern (20, 20', ...) und axiale Bewegung des unmittelbar am Schlitz (6) befindlichen Schiebers (20) zeitlich nacheinander so aufeinander abgestimmt sind, daß ein Drehschritt mit einem Winkelabstand zweier in Drehrichtung benachbarter Schieber (20, 20') durchgeführt wird, wobei die bereits gefalteten Gurtbandabschnitte durch den ablaufenden Schieber bzw. dessen Stift weiter in Stapelrichtung bewegt werden, daß der Drehantrieb (26) stillgesetzt wird, daß der unmittelbar dem Schlitz (6) zugeordnete oberste Schieber (20) durch einen hin- und hergehenden Antrieb (25) in axialer Richtung auf die gegenüberliegende Seite verschoben wird, wobei durch diese Verschiebung das Gurtband (4) bis zum gegenüberliegenden Ende mitgenommen wird, daß anschließend die Drehvorrichtung (26) wie um einen Schritt durch den soeben angekommenen Stift (21) weitergedreht wird, daß der nächstfolgende Schieber (20) auf dieser Seite in Anlage gegen das Gurtband (4) kommt, auf die entgegengesetzte Seite in axialer Richtung verschoben wird und damit das Gurtband (4) in seiner Position der Stiftbewegung in axialer Richtung liegt, usw., derart, daß immer ein Drehschritt und ein Axialschritt miteinander abwechseln, wobei der Drehschritt die Vorwärtsbewegung des bereits gefalteten Gurtbandes (4) und die Axialbewegung das Falten des jeweiligen Gurtbandabschnittes ergibt.

5. Einrichtung nach einem der Ansprüche 1 bis 4, dadurch gekennzeichnet, daß die Drehvorrichtung (16) eine Trommel ist, deren Mantelfläche aus mit den Trommelstirnflächen in Verbindung stehenden, in gleichem Abstand auf der Trommeloberfläche versetzten Stäben (19, 19', ...) besteht, auf denen die Schieber (20, 20', ...) in axialer Richtung verschiebbar sind.

6. Einrichtung nach einem der Ansprüche 1 bis 5, dadurch gekennzeichnet, daß jeder Schieber (20, 20', ...) durch einen doppelt wirkenden Druckzylinder (25) von einem Ende des Stabes (19, 19', ...) zum anderen verschiebbar ausgebildet ist.

7. Einrichtung nach einem der Ansprüche 1 bis 6, dadurch gekennzeichnet, daß jeder Schieber (20, 20', ...) eine Aussparung aufweist, in die ein Mitnahmeelement, z. B. eine Nase (22), des Druckzylinderantriebs eingreift, und daß das Herstellen und Lösen dieser Verbindung selbsttätig durch Drehen der Trommel (16) erfolgt, welche vorzugsweise durch einen Servorantrieb, z. B. einen Schrittmotor angetrieben ist.

8. Einrichtung nach einem der Ansprüche 1 bis 7, dadurch gekennzeichnet, daß jeweils zwei benachbarte Schieber (20, 20', ...) auf ihren Stäben (19, 19', ...) an entgegensetzten Stirnseiten der Trommel vorgesehen sind, mit Ausnahme der Startposition des Faltvorganges, an der zwei Schieber auf der einen Trommelseite angeordnet sind, während die gegenüberliegende Seite der beiden Stäbe frei von Schiebern ist.

9. Einrichtung nach einem der Ansprüche 1 bis 8, dadurch gekennzeichnet, daß in Höhe des Querschlitzes (6) Sperrvorrichtungen (29, 30), z. B. in Form von Blattfederelementen an den Seitenwänden (2, 3) des Sammelbehälters (1) vorgesehen sind, die als Arretierung für die jeweiligen gelegten Abschnitte des Gurtbandes (4) dienen und die von den Seitenwänden weg nach innen in den Gurtaufnahmeraum federnd angeordnet sind.

10. Einrichtung nach einem der Ansprüche 1 bis 9, dadurch gekennzeichnet, daß quer zur Längsachse des Sammelbehälters (1) eine Schieberklappe (15) angeordnet ist, die als Anlage für die gelegten Gurtbandabschnitte dient, die in Längsrichtung des Sammelbehälters verschiebbar ausgebildet ist, und die vorzugsweise an einer parallel zur Längsachse des Sammelbehälters angeordneten Führungsachse geführt und gelargert ist und an einer der beiden Seitenwände (2, 3) ein einen wesentlichen Teil des Sammelbehälters (1) übergreifender Deckel (28) gelagert ist, der die gefalteten Gurtbandabschnitte niederhält, und der vorzugsweise aus Plexiglas besteht.

11. Einrichtung nach einem der Ansprüche 1 bis 10, dadurch gekennzeichnet, daß dem Gurtbandeinlauf eine Prägevorrichtung (31) zugeordnet ist, die im Abstand der zu faltenden Gurtbandabschnitte eine Sollknickstelle in Form einer Zweifachkerbe prägt, die exakt an der Begrenzung eines im Gurtband (4) angeordneten Bauteiles bzw. so geprägt ist, daß bei zwei benachbarten gefalteten Gurtbandabschnitten die Bauteile des einen Gurtbandabschnittes in die Freistelle zwischen zwei benachbarten Bauteilen des unmittelbar anschließenden Gurtbandabschnittes zu liegen kommen.

## Claims

1. Device for the meandering-like laying of bands, ribbons, belts or similar endless strip-like materials, in particular belt bands containing electrical or electronic components, characterised by a collecting platform (1) to accomodate the folded belt band (4) with a I-slit (6) in the floor (5) of the platform (1) and a rotation device (16) associated with the slit (6) with at least one axially movable slide member (20, 20', ...), which can rotate together with the rotation device (16) and has a pin (21, 21'), ...) passing through the slit (6) and in engagement with the belt band (4).

2. Device according to claim 1, characterised in that the slide members (20, 20', ...), with the rotation device (16) stationary, can be displaced in their position immediately underneath the slit (6) in the axial direction in engagement with the belt band (4) and can execute in their axial end positions a rotational movement together with the rotation device (16).

3. Device according to claim 1 or 2, characterised in that the rotational movement of the rotation device (16) together with the slide members (20, 20', ...) and the axial movement in each case of the slide member (20) located at the slit (6) with the rotation device (16) stationary takes place in sequence in a stepwise manner, and that the belt band (4) is taken by the axial movement of the slide member (20) from one end to the axially opposite end of the rotation device (16), during which the rotational movement of the respective slide member (20) displaces the belt band (4) further in the rotational direction on the collecting platform (1).

4. Device according to one of claims 1 to 3, characterised in that the rotational movement of the rotation device (16) with the slide members (20, 20', ...) and the axial movement of the slide member (20) located immediately at the slit (6) are adjusted timewise with respect to one another so that a rotational step is executed with an angular spacing of two adjacent slide members (20, 20') in the rotational direction, wherein the already folded belt band sections are moved by the proceeding slide member or its pin further in the stacking direction, in that the uppermost slide member (20) associated directly with the slit (6) is displaced by a reciprocating drive (25) in the axial direction to the opposite side, wherein the belt band (4) is taken by this displacement to the opposite end, in that the rotation device (16) is then rotated further by one step by the pin (21) that has just arrived, and in that the immediately following slide member (20) on this side comes to rest against the belt band (4), is displaced to the opposite side in the axial direction, and thus the belt band (4) lies in its position of the pin movement in the axial direction, etc., so that a rotation step and an axial step always alternate, wherein the rotational step produces the forward movement of the already folded belt band (4) and the axial movement produces the folding of the respective belt band section.

5. Device according to one of claims 1 to 4, characterised in that the rotation device (16) is a drum whose surface consists of rods (19, 19', ...) connected to the faces of the drum and equidistantly spaced on the drum surface, on which rods the slide members (20, 20', ...) can be displaced in the axial direction.

6. Device according to one of claims 1 to 5, characterised in that each slide member (20, 20', ...) is formed by a double-acting pressure cylinder (25) that can be moved from one end of the rod (19, 19', ...) to the other end.

7. Device according to one of claims 1 to 6, characterised in that each slide member (20, 20', ...) has a recess in which a take-up element, e. g. a driver (22), of the pressure cylinder drive engages, and in that this connection is automatically formed and released by rotation of the drum (16), which is preferably driven by a servodrive, e. g. a stepping motor.

8. Device according to one of claims 1 to 7, characterised in that in each case two adjacent slide members (20, 20', ...) are provided on their rods (19, 19' ...) on opposite faces of the drum, with the exception of the starting position of the folding procedure, at which two slide members are arranged on one drum side, while the opposite side of the two rods is free of slide members.

9. Device according to one of claims 1 to 8, characterised in that at the height of the transverse slit (6) locking devices (29, 30) e. g. in the form of leaf spring elements, are provided on the side walls (2, 3) of the collecting platform (1), which serve to arrest the respective laid sections of the belt band (4) and which are arranged in an elastic manner from the side walls inwardly into the belt accomodation space.

10. Device according to one of claims 1 to 9, characterised in that a slide member flap (15) is arranged transverse to the longitudinal axis of the collecting platform (1), which serves as a bearing surface for the laid belt band sections, which is displaceable in the longitudinal direction of the collecting platform, and which is preferably guided and mounted on a guide shaft arranged parallel to the longitudinal axis of the collecting platform, and a cover (28) enclosing a substantial part of the collecting platform (1) is mounted on one of the two side walls (2, 3), which holds down the folded belt band sections and which is preferably made of Plexiglass.

11. Device according to one of claims 1 to 10, characterised in that an embossing or stamping device (31) is associated with the belt band run-in, which stamps a target bending point in the form of a double notch at the spacing of the belt band sections to be folded, which notch is stamped exactly at the boundary of a structural member arranged in the belt band (4) so that with two adjacent folded belt band sections the structural components of one belt band section come to lie in the free position between two adjacent structural components of the immediately following belt band section.

**Revendications**

1. Dispositif pour déposer en couches en accordéon des matériaux en bandes continues, en particulier des bandes garnies de composants électriques ou électroniques, caractérisé en ce qu'il comporte une plate-forme de guidage (1) pour recevoir la bande pliée (4), le fond (5) de cette plate-forme (1) étant pourvu d'une fente en forme de I (6), à laquelle est associé un système tournant (16) ayant au moins un coulisseau (20, 20', ...) mobile dans le sens axial, qui peut tourner avec le système tournant (16), et qui porte un doigt (21, 21', ...) pouvant passer à travers la fente (6) pour agir sur la bande (4).

2. Dispositif selon la revendication 1, caractérisé en ce que les coulisseaux (20, 20', ...), en position d'arrêt du système tournant (16), et lorsqu'ils se trouvent dans une position située immédiatement en-dessous de la fente (6), peuvent se déplacer dans le sens axial en agissant sur la bande (4), les coulisseaux pouvant dans leur position axiale extrême effectuer un mouvement de rotation avec le système tournant (16).

3. Dispositif selon l'une des revendications 1 ou 2, caractérisé en ce que le mouvement de rotation du dispositif tournant (16) avec les coulisseaux (20, 20', ...), et le mouvement axial de chacun des coulisseaux (20) qui se trouve en regard de la fente (6) à l'arrêt du système tournant (16), s'effectuent l'un après l'autre avec un déclage : et en ce que la bande (4) se trouve entraînée par le mouvement axial du coulisseau (20), d'une extrémité du système tournant (16) à l'extrémité axialement opposée de celui-ci ;

cependant que la bande (4) avance sur la plate-forme de guidage (1), sous l'effet du mouvement de rotation de chaque coulisseau (20), dans le sens de rotation de celui-ci.

4. Dispositif selon l'une des revendications 1 à 3, caractérisé en ce que le mouvement de rotation du système tournant (16) avec les coulisseaux (20, 20', ...), et le mouvement axial du coulisseau (20) situé immédiatement en-dessous de la fente (6), sont conjugués pour s'effectuer l'un après l'autre, de manière à faire effectuer au système une rotation élémentaire, correspondant à la distance angulaire de deux coulisseaux (20, 20') successifs dans le sens de la rotation ; les parties déjà pliées de la bande se trouvant ainsi déplacées, dans le sens d'empilage de la bande, par le doigt du coulisseau descendant ; en ce que le mécanisme d'entraînement en rotation s'arrête alors ; en ce que le coulisseau (20) situé le plus haut immédiatement en-dessous de la fente (6) est poussé du côté opposé dans le sens axial, par un mécanisme de va-et-vient (25), la bande (4) se trouvant ainsi entraînée jusqu'à l'extrémité opposée ; en ce que le système tournant (16) se trouve alors déplacé en rotation d'une distance angulaire élémentaire, par le doigt (21) qui arrive en même temps ; en ce que le coulisseau suivant (20) vient alors en appui contre la bande (4) de ce côté, puis se trouve poussé de l'autre côté dans le sens axial, et dépose ainsi la bande (4) dans sa position du mouvement du doigt dans le sens axial, et ainsi de suite, de telle manière qu'un déplacement élémentaire en rotation et un déplacement élémentaire dans le sens axial se succèdent constamment, tour-à-tour ; le mouvement élémentaire en rotation assurant le mouvement d'avance de la bande (4) déjà pliée, tandis que le mouvement axial assure le pliage de chacune des parties concernées de la bande.

5. Dispositif selon l'une des revendications 1 à 4, caractérisé en ce que le système tournant (16) est constitué par un tambour, dont la paroi latérale est formée par des barreaux (19, 19', ...) équidistants reliés aux deux extrémités du tambour, et en retrait par rapport à la surface virtuelle du tambour ; et en ce que les coulisseaux (20, 20', ...) sont montés sur les barreaux (19, 19', ...), et peuvent se déplacer axialement sur ceux-ci.

6. Dispositif selon l'une des revendications 1 à 5, caractérisé en ce que chaque coulisseau (20, 20', ...) peut se déplacer d'une extrémité à l'autre du barreau (19, 19', ...), sous l'action d'un vérin à double effet (25) commandé par un fluide sous pression.

7. Dispositif selon l'une des revendications 1 à 6, caractérisé en ce que chaque coulisseau (20, 20', ...) comporte un évidement (23) dans lequel peut s'engager un organe d'actionnement du vérin (25), tel qu'un bec (22) ; et en ce que l'établissement et la libération de cette liaison s'effectuent automatiquement, sous l'effet de la rotation du tambour (16), celui-ci étant de préférence commandé par un système d'entraînement asservi, tel qu'un moteur pas à pas.

8. Dispositif selon l'une des revendications 1 à 7, caractérisé en ce que les coulisseaux adjacents (20, 20', ...) sont disposés à tour de rôle sur leurs barreaux (19, 19', ...), tantôt à une extrémité du tambour, et tantôt à l'extrémité opposée ; à l'exception de la position de départ du processus de pliage, à laquelle correspondant deux coulisseaux disposés du côté de la même extrémité du tambour, alors que l'extrémité opposée des deux barreaux concernés n'a pas de coulisseau.

9. Dispositif selon l'une des revendications 1 à 8, caractérisé en ce que des organes d'arrêt (29, 30), constitués par exemple par des lames de ressorts, sont prévus en regard des parois latérales (2, 3) de la plate-forme de guidage (1) ; ces organes d'arrêt servant à arrêter chacune des parties de la bande (4) déposées à tour de rôle : ces organes d'arrêt tendant à s'écarter élastiquement des parois latérales de la plate-forme de guidage, vers l'intérieur de la zone où arrive la bande à plier (4).

10. Dispositif selon l'une des revendications 1 à 9, caractérisé en ce qu'il comporte un volet coulissant (15), transversal à l'axe longitudinal de la plate-forme de guidage (1) ; ce volet coulissant servant d'appui aux parties de la bande (4) déposées en plis ; ce volet d'appui (15) pouvant coulisser dans le sens de la longueur de la plate-forme de guidage (1) et étant de préférence monté à coulisse sur une tige de guidage parallèle à l'axe longitudinal de la plate-forme (1) ; le volet d'appui (15) étant solidaire d'un couvercle (28), disposé en regard de l'une des parois latérales (2, 3) et recouvrant une partie importante de la plate-forme de guidage (1) ; ce couvercle (28) maintenant vers le bas les parties pliées de la bande (4), et étant confectionné de préférence en « Plexiglas ».

11. Dispositif selon l'une des revendications 1 à 10, caractérisé en ce qu'il comporte un système de mise en forme (31), à l'endroit où arrive la bande ; ce système de mise en forme effectuant de place en place, le long de la bande à plier, l'impression d'une double empreinte à l'endroit prévu pour chaque pliure de la bande, exactement à la limite de l'emplacement d'un composant fixe à la bande (4) ; pour que les parties pliées adjacentes de la bande se trouvent disposées de telle manière que les composants fixés à une partie de la bande soient placés entre les composants fixés à la partie contiguë de la bande pliée.

Fig.1

Fig.2

Fig.6

Fig.5

Fig.7

Fig.3

11

21  20  21'  19'  20'  21''

4

19  19''

23  20''

19

16

22  24

14

0 050 865

Fig.4